# EUROPEAN PATENT SPECIFICATION

(11) **EP 3 403 993 B1**
(45) Date of publication and mention of the grant of the patent: **30.06.2021**
(21) Application number: 17171793.7
(22) Date of filing: 18.05.2017
(51) Int. Cl.: B81C 1/00

(54) **SEMICONDUCTOR CHIP**
HALBLEITERCHIP
PUCE À SEMI-CONDUCTEUR

(43) Date of publication of application: 21.11.2018
(73) Proprietor: Sensirion AG, 8712 Stäfa (CH)
(72) Inventor: Wüest, Robert, 8712 Stäfa (CH); Merz, Matthias, 8712 Stäfa (CH); Studer, Matthias, 8712 Stäfa (CH); Kölbl, Dominikus, 8712 Stäfa (CH); Van Steenwijk, Gijs, 8712 Stäfa (CH); Kümin, Cyrill, 8712 Stäfa (CH)
(74) Representative: Meyer, Michael Josef

(56) References cited:
- US-A1- 2006 076 651
- US-A1- 2010 084 723
- US-A1- 2014 319 693

## Description

### Technical Field

The present invention relates to a semiconductor chip, in particular a semiconductor sensor chip having a sensor device and processing circuitry for processing signals of the sensor device.

### Background Art

Subject to the application, sensor devices tend to be integrated on semiconductor substrates. This kind of manufacturing is beneficial in that the size of the sensor device can significantly be reduced compared to discrete type sensor devices, and a corresponding sensing element can be arranged together with processing circuitry integrated on the same semiconductor substrate. The processing circuitry may include functions acting on a signal delivered by the sensor device such as amplification, evaluation, etc.

Multiple sensor chips are manufactured from a common wafer, where the individual sensor chips are separated from the wafer e.g. by dicing the wafer. During the process of dicing, a sensor device or processing circuitry if any may be impacted, for example, by cracks induced during the dicing process, or by contaminants infiltrated during the dicing process.

In order to avoid such damaging of the sensor chip, a seal ring may be provided at the edge of the chip around the sensor device and the processing circuitry if any. Such a seal ring may comprise a metal ring for protection purposes.

US 2014/0319693 A1 discloses a method of forming a semiconductor device. Provided is a substrate having at least one MOS device, at least one metal interconnection and at least one MOS device formed on a first surface thereof. A first anisotropic etching process is performed to remove a portion of the substrate from a second surface of the substrate and thereby form a plurality of vias in the substrate, wherein the second surface is opposite to the first surface. A second anisotropic etching process is performed to remove another portion of the substrate from the second surface of the substrate and thereby form a cavity in the substrate, wherein the remaining vias are located below the cavity. An isotropic etching process is performed to the cavity and the remaining vias.

US 2006/0076651 A1 discloses an electronic device which has an element formed in the chip region of a substrate, a plurality of interlayer insulating films formed on the substrate, a wire formed in the interlayer insulating films in the chip region, and a plug formed in the interlayer insulating films in the chip region and connecting to the wire. A seal ring extending through the plurality of interlayer insulating films and continuously surrounding the chip region is formed in the peripheral portion of the chip region. A stress absorbing wall extending through the plurality of interlayer insulating films and discretely surrounding the seal ring is formed outside the seal ring.

US 2010/084723 A1 discloses a MEMS structure and a method of manufacturing the same. The MEMS structure includes a substrate and at least one suspended microstructure located on the substrate. The suspended microstructure includes a plurality of metal layers, at least one dielectric layer, and at least one peripheral metal wall. The dielectric layer is sandwiched by the metal layers, and the peripheral metal wall is parallel to a thickness direction of the suspended microstructure and surrounds an edge of the dielectric layer.

US 2011/068374 discloses an integrated circuit (IC) having a microelectromechanical system (MEMS) device buried therein. The integrated circuit includes a substrate, a metal-oxide semiconductor (MOS) device, a metal interconnect, and the MEMS device. The substrate has a logic circuit region and a MEMS region. The MOS device is located on the logic circuit region of the substrate. The metal interconnect, formed by a plurality of levels of wires and a plurality of vias, is located above the substrate to connect the MOS device. The MEMS device is located on the MEMS region, and includes a sandwich membrane located between any two neighboring levels of wires in the metal interconnect and connected to the metal interconnect.

US 2016/0244326 A1 discloses a semiconductor element and method. The method includes providing a processed substrate arrangement including a processed semiconductor substrate and a metallization layer structure on a main surface of the processed semiconductor substrate. The method further includes release etching for generating a kerf in the metallization layer structure at a separation region in the processed semiconductor substrate, the separation region defining a border between a die region of the processed substrate arrangement and at least a second region of the processed substrate arrangement.

It is an object of embodiments of the present invention to provide a semiconductor chip which further facilitates the integration of sensor devices together with processing circuitry on a common substrate.

It is a further object of embodiments of the invention to improve the reliability of semiconductor chips comprising sensor devices which are integrated with processing circuitry on a common substrate.

### Disclosure of the Invention

The invention is disclosed in the claims. According to an embodiment of a first aspect of the invention, there is provided a semiconductor chip comprising a substrate and a stack arranged on the substrate. The stack comprises one or more insulating layers and one or more metal layers. The chip comprises a sensor device arranged in a sensor area of the semiconductor chip and processing circuitry arranged in a processing area of the semiconductor chip. The chip further comprises connection circuitry configured to provide an electrical connection between the sensor device and the processing circuitry. A first seal ring structure is arranged between an outer edge of the chip and an inner area of the chip. The first seal ring is in particular configured to protect the inner area of the chip from lateral impact. The inner area of the chip encompasses the sensor area and the processing area. A second seal ring structure is arranged between the sensor area and the processing area and is configured to constrain an infiltration of contaminants from the sensor area to the processing area.

The semiconductor chip comprises a passivation layer arranged at least partly on top of the stack. The first seal ring structure and the second seal ring structure are implemented in the stack between the substrate and the passivation layer. The second seal ring structure is a closed seal ring structure. The closed seal ring structure provides a closed seal ring between the substrate and the passivation layer. The closed seal ring structure is electrically insulated from the sensor device and the processing circuitry. The semiconductor chip comprises as connection circuitry a contact layer arranged on top of the passivation layer. The contact layer is configured to contact the sensor device through an opening of the passivation layer.

Such a semiconductor chip facilitates the integration of sensor devices and corresponding processing circuitry on a single semiconductor chip. The arrangement of the second seal ring between the sensor area and the processing area improves the reliability of the processing circuitry. Aspects of the invention are based on a finding/discovery of the inventors of the present invention that sensor devices that are integrated together with processing circuitry on the same semiconductor chip may adversely affect the functioning and/or reliability of the processing circuitry as well as the functioning of the connection circuitry. This applies in particular to sensor devices that are configured to interact with the ambience of the sensor device, in particular the ambient air. More particularly, sensor devices that are configured to interact with the ambience of the sensor area/sensor device may comprise openings that may provide an infiltration path for contaminants to enter the stack.

This is of particular relevance for processing circuitry and connection circuity that is implemented in CMOS technology and is hence rather sensitive to such contaminants.

The term processing circuitry shall denote any kind of electronic circuitry that may be used to process sensor signals of the sensor device.

The term contaminants shall denote any kind of elements, compositions or materials that may adversely affect the components of the stack, in particular the processing circuitry.

Contaminants may include in particular humidity and ions.

Aspects of the invention are particularly advantageous for the integration of sensor devices and MEMS devices that comprise a cavity, a recess or an opening in the substrate and/or an opening in the passivation. The second seal ring structure according to embodiments of the invention may effectively shield or seal such recesses or openings of the substrate, thereby avoiding that contaminants such as chemicals, humidity or ions may enter the (oxide) stack during the lifetime of the chip. Hence embodiments of the invention prevent that contaminants may diffuse via the sensor device/sensor area into the CMOS-area of the semiconductor chip.

This may significantly improve the reliability of such integrated chips.

Generally, the terms first ring structure and second ring structure shall denote any kind of loops that surround or enclose the inner area and that surround or encloses the sensor area respectively. The loop may be a closed loop without any openings for connection circuitry or an open loop with openings for connection circuitry as will be explained further below in more detail. The loop may have various forms such as a circle, an annulus, a polygon or other suitable free form loops in dependence on the geometry of the respective chip.

Arranging the passivation layer at least partly on top of the stack and implementing the first seal ring structure and the second seal ring structure in the stack between the substrate and the passivation layer is an effective way to implement the first and the second seal ring. The substrate preferably comprises or consists of a material that provides a diffusion barrier, in particular bulk silicon. The passivation layer preferably comprises or consists of a material that provides a diffusion barrier as well. This provides a kind of top cover and bottom cover to shield against the infiltration of contaminants. The first seal ring and the second seal ring establish vertical side barriers or in other words vertical side walls between the edge of the chip and the inner area of the chip and between the sensor area of the chip and the processing area of the chip respectively. This protects the processing circuitry and the connection circuitry from external contaminants. Preferably the first and/or the second seal ring structure are directly connected to or attached to the passivation layer and to the substrate.

Hence according to embodiments the passivation layer, the substrate/bulk silicon, the first seal ring structure and the second seal ring structure provide an enclosure for the processing circuitry that serves as a diffusion barrier. The closed seal ring structure does not comprise any openings for electrical feed through connections and is electrically insulated from the sensor device and the processing circuitry. Such a closed seal ring structure may completely seal the sensor area/sensor device from the processing area/processing device for any diffusion.

In order to provide an electrical connection between the sensor device and the processing circuitry, the semiconductor chip with the closed seal ring structure comprises as electrical connection circuitry a contact layer arranged on top of the passivation layer. The contact layer is configured to contact the sensor device through an opening of the passivation layer. This provides an electrical connection between the sensor device and the processing circuitry outside of the CMOS stack and by bypassing the closed seal ring structure.

According to a further embodiment, the second seal ring structure is a conductive structure arranged in the stack and the second seal ring structure is formed by a plurality of metal layers which are electrically connected by interconnect elements.

Such an embodiment of the closed seal ring structure can be efficiently and reliably fabricated by standard CMOS processes.

According to an embodiment of another aspect of the invention, there is provided a semiconductor chip comprising a substrate, a stack of one or more insulating layers and one or more metal layers arranged on the substrate, a sensor device arranged in a sensor area of the semiconductor chip and processing circuitry arranged in a processing area of the semiconductor chip. The semiconductor chip further comprises connection circuitry configured to provide an electrical connection between the sensor device and the processing circuitry, a first seal ring structure arranged between an outer edge of the chip and an inner area of the chip. The inner area encompasses the sensor area and the processing area. A second seal ring structure is arranged between the sensor area and the processing area and is configured to constrain an infiltration of contaminants from the sensor area to the processing area. The second seal ring structure is configured as open seal ring structure comprising one or more openings for one or more electrical feed through connections. The one or more electrical feed through connections are configured to provide an electrical connection between the sensor device and the processing circuitry. The second seal ring structure comprises a conductive structure arranged in the stack and the electrical feed through connections are implemented by two or more different metal layers of the stack which are electrically connected by interconnect elements. The feed through connections are arranged in such a way that a direct diffusion path between the sensor area and the processing area is blocked.

This is an elegant, simple and efficient way to implement on the one hand an electrical connection between the sensor device and the processing circuitry and to constrain on the other hand any infiltration of contaminants. In this respect the second seal ring according to such an embodiment serves two purposes or in other words has a dual use.

Such a blocking of the direct diffusion path results in an extension or elongation of the remaining diffusion paths, decreases a possible contamination and hence increases the reliability of the components of the CMOS stack.

According to a further embodiment, the semiconductor chip comprises a further passivation layer arranged between the sensor area and the processing area and configured to shield the processing area from the sensor area, in particular to shield the processing area from diffusion of contaminants.

Such an additional passivation layer may be used to further reduce or constrain possible diffusion paths and may provide an additional barrier for contaminants to enter the CMOS stack. Such a further passivation layer may be arranged in particular adjacent to recesses, openings or cavities of the sensor device.

As described above, the second seal ring structure may effectively block or reduce diffusion paths from the ambiance, in particular the ambient air, into the CMOS stack.

Hence embodiments of the invention encompass in particular semiconductor chips with a sensor area that comprises recesses, openings and/or cavities in the substrate. More particularly, according to embodiments, the recesses, openings or cavities are provided in the bulk substrate and are etched from the bulk side or in other words from the bottom side of the semiconductor chip.

According to some embodiments, the etching of the substrate may be performed in such a way that it just stops at the vertical lower edge of the stack. According to other embodiments, the etching may also remove a part of the stack in addition to the etching of the substrate such that the recess or opening extends from the substrate into the stack.

Further embodiments encompass sensor devices with sensor areas having a passivation layer with at least one opening in the sensor area.

Furthermore, embodiments of the invention encompass sensor devices with bridge structures that carry one or more sensing elements of the sensor device. The diffusion paths that such recesses, openings, cavities, bridge structures or openings may provide can be effectively shielded with a chip architecture according to embodiments of the invention.

While generally the invention may be used for any kind of sensor device or MEMS device that shall be integrated with CMOS processing circuitry, particularly preferred embodiments encompass environmental sensor devices that interact with the environment of the sensor for measuring and/or sensing purposes. Sensor devices according to embodiments of the invention include in particular flow sensors, humidity sensors, MOX gas sensors, electro-chemical cells or infrared sensors.

A further aspect of the invention also applies to electronic devices, in particular portable electronic devices that comprise a semiconductor chip as described above. Using chips according to embodiments of the invention for such electronic devices provide advantages in terms of miniaturization, integration and reliability of the electronic devices.

Preferably, multiple semiconductor chips are manufactured from a common wafer. Hence, aspects of the invention also relate to a wafer comprising a plurality of semiconductor chips according to the first aspect.

### Brief Description of the Drawings

The embodiments defined above and further embodiments, features and advantages of the present invention can also be derived from the examples of embodiments to be described hereinafter in connection with the drawings in which the figures illustrate:
FIG. 1 shows a cross section of a semiconductor chip according to an embodiment of the invention;
FIG. 2 shows a 3-dimensional view of a semiconductor chip according to an embodiment of the invention;
FIG. 3 shows a schematic top view of a semiconductor chip according to an embodiment of the invention;
FIG. 4 shows a schematic top view of a semiconductor chip comprising a seal ring with openings for electrical feed through connections according to an embodiment of the invention;
FIG. 5 shows a cross section of a semiconductor chip according to an embodiment of the invention;
FIG. 6 shows a cross section of a semiconductor chip comprising a contact layer on top of the passivation layer according to another embodiment of the invention;
FIG. 7 shows a cross section of a semiconductor chip comprising an additional passivation layer according to another embodiment of the invention; and
FIG. 8 shows a schematic top view of a semiconductor chip comprising bridge structures according to another embodiment of the invention.

### Modes for Carrying Out the Invention

The drawings are provided for illustration purposes and may be not to scale. Identical or similar elements are referred to by the same reference numerals.

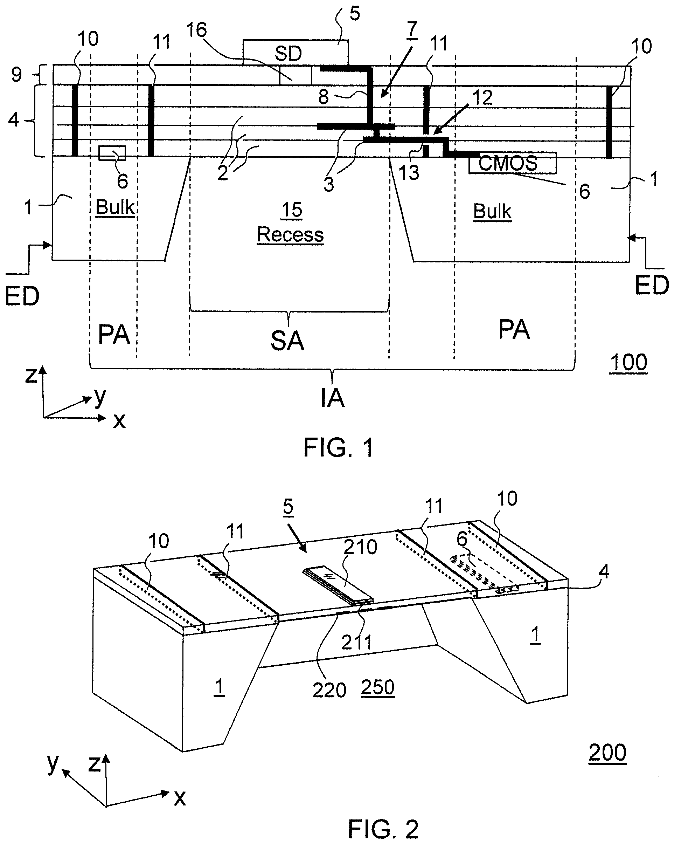

FIG. 1 shows a cross section of a semiconductor chip 100 according to an embodiment of the invention.

The semiconductor chip 100 comprises a substrate 1 such as a silicon substrate. A stack of insulating/dielectric layers 2 and metal layers 3 is arranged on the substrate 1 and is collectively referred to by 4. The dielectric layers 2 of this stack 4 may contain SiO or SiN and the metal layers 3 may contain Al, W or Cu.

According to this embodiment, a sensor device 5 is arranged on top of the stack 4. However, according to other embodiments the sensor device 5 may also be embedded in the stack 4, or arranged on the substrate 1.

In addition, processing circuitry 6 is integrated in the stack 4 for processing signals of the sensor device 5 of the semiconductor chip 100. The layers of the stack 4 are preferably CMOS layers.

The semiconductor chip 100 has a plane extending in an x/y direction and comprises a sensor area SA and a processing area PA in this plane.

The sensor device 5 is arranged in the sensor area SA and the processing circuitry 6 is arranged in the processing area PA. The semiconductor chip 100 further has an inner area IA that encompasses the sensor area SA and the processing area PA.

The semiconductor chip 100 comprises a recess or opening 15 in the substrate 1 and more particularly in the sensor area SA of the chip 100. The recess or opening 15 may be etched from the bulk side/substrate side or in other words from the bottom side of the semiconductor chip 100. Top and bottom refer in this context to the vertical z-direction.

According to the illustration of FIG. 1, the etching of the substrate 1 has been performed in such a way that the vertical top side/top plane of the recess or opening 15 corresponds to the vertical lower side/lower plane of the stack 4. According to other embodiments, the recess or opening 15 may also encompass CMOS layers of the stack 4 or in other words the recess or opening 15 may extend into the stack 4. The recess or opening 15 may be provided e.g. for thermal insulation purposes of the sensor device, e.g. for an MOX gas sensor device.

The semiconductor chip 100 further comprises connection circuitry 7 which provides an electrical connection between the sensor device 5 and the processing circuitry 6. The connection circuitry 7 comprises as horizontal conducting elements (in the x-y plane) a plurality of metal layers 3 and interconnect elements 8, embodied as vias, which provide an electric connection between metal layers of different planes in the vertical z-direction through corresponding insulating layers 2. One or more of the metal layers 3 may also be used for building contact pads for contacting the semiconductor chip 100 from the outside.

The semiconductor chip 100 comprises a passivation layer 9 arranged at least partly on top of the stack 4. The passivation layer 9 is inert and prevents the diffusion of contaminants such as humidity and ions into the stack 4.

The semiconductor chip 100 comprises a first seal ring structure 10 arranged between an outer edge ED of the chip 100 and the inner area IA of the chip 100.

The first seal ring structure 10 protects the inner area IA of the semiconductor chip 100 from lateral impact and in furthermore prevents the diffusion of contaminants such as humidity and ions into the stack 4. The first seal ring structure 10 is implemented in the stack 4 and extends between the substrate 1 and the passivation layer 9. It may be in particular formed as conductive and closed structure by metal layers 3 and interconnect elements 8, thereby forming a closed barrier for the diffusion of contaminants.

The passivation layer 9 may comprise according to embodiments one or more openings 16 in the sensor area SA. The opening 16 is shown in FIG. 1 in a schematic way.

The semiconductor chip 100 further comprises a second seal ring structure 11 arranged between the sensor area SA and the processing area PA. The second seal ring structure 11 constrains and preferably prevents an infiltration of contaminants from the sensor area SA or the ambiance of the sensor area SA to the processing area PA.

The second seal ring structure 11 is also implemented in the stack between the substrate 1 and the passivation layer 9. It may be formed as conductive structure comprising metal layers 3 and interconnect elements 8.

According to the embodiment of FIG 1, the second seal ring structure 11 is configured as open seal ring structure and accordingly it comprises one or more openings 12 for one or more electrical feed through connections 13. The feed through connections 13 form a part of the connection circuitry 7 and provide an electrical connection via the opening 12 between the sensor device 5 and the processing circuitry 6.

The term sensor device shall be understood in a broad sense and shall in particular encompass any kind of microelectromechanical systems (MEMS) devices.

Hence the sensor device 5 may be in particular a microelectromechanical system (MEMS) device. In this respect, the terms MEMS shall be understood in a broad sense and shall include also devices without moving parts. Rather the term MEMS shall include devices and structures that are made using the techniques of microfabrication and in particular devices and structures that are fabricated with non-CMOS processes. The terms MEMS shall include in particular any kind of micro-sensors. According to preferred embodiments the sensor device 5 may be a flow sensor, a MOX gas sensor, a humidity sensor, an electro-chemical cell or an infrared (IR) sensor.

The processing circuitry 6 is in particular CMOS circuitry and hence sensitive to contaminants such as humidity and ions.

FIG. 2 shows a 3-dimensional partial view (cut away view) of a part of a semiconductor chip 200 according to an embodiment of the invention, which may partly correspond to the semiconductor chip 100 of FIG. 1. The semiconductor chip 200 is configured as gas sensor and hence configured to measure a gas concentration of a target gas in a sample of ambient air.

The semiconductor chip 200 comprises as sensor device 5 a gas sensitive component 210. The gas sensitive component 210 comprises a gas sensitive layer 211. The gas sensitive layer 211 comprise a gas sensitive sensing material. The sensing material is a material that changes at least one electrical property (in particular the real or imaginary part of its electrical impedance) as a function of the composition of the gas that surrounds it. The change of the property can be measured in order to obtain information on said composition. The sensing material of the gas sensitive layer 211 can e.g. contain at least one metal oxide material. Such metal oxide material may include one or more of tin oxide, zinc oxide, titanium oxide, tungsten oxide, indium oxide and gallium oxide. Such metal oxides may be used for the detection of various analytes as target gas such as ozone, VOCs, carbon monoxide, nitrogen dioxide, methane, ammonia, hydrogen, or hydrogen sulphide.

Metal oxide sensors are based on the concept that gaseous analytes interact with the metal oxide layer at elevated temperatures of the sensitive layer in the range of more than 100 °C, and specifically between 250 °C and 450 °C. As a result of the catalytic reaction, the conductivity of the gas sensitive layers may change, which change can be measured. Hence, such sensors are also denoted as high temperature chemoresistors for the reason that a chemical property of the analyte is converted into an electrical resistance at high temperatures of the gas sensitive layers.

The semiconductor chip 200 is integrated with CMOS circuitry 6 as processing circuitry.

The semiconductor chip 200 comprises a stack 4 of CMOS layers and a substrate 1 establishing a handle layer. Parts of the CMOS layers and of the handle layer are etched away to form a cavity 250 at the location of the gas sensitive layer 211. The remaining CMOS layers form a thin membrane to support the gas sensitive component 210. The cavity 250 may correspond to the recess or opening 15 illustrated in FIG. 1.

Embedded within the CMOS layers are heating elements 220 forming a heater to provide a local source of heat to heat the gas sensitive component 210 during operation. The temperature can rise rapidly around the gas sensitive component 210, while the thicker part of the semiconductor chip reacts due to its thermal inertia with a slower rise of temperature. By controlling the heating elements 220 accordingly, the material, in particular the metal oxide, of the gas sensitive layer 210 can be activated for a measurement and subsequent regeneration.

The gas sensitive layer 210 is contacted by measuring electrodes (not shown) and hence acts as a resistor. In the presence of a target gas as analyte, the respective resistance of the gas sensitive layer 210 changes and thereby provides a measure of the concentration of the target gas in the sample of ambient air in the immediate vicinity of the gas sensitive layer 210.

The semiconductor chip 200 comprises a first seal ring structure 10 and a second seal ring structure 11 as described with reference to FIG. 1. The second seal ring structure 11 constrains in particular an infiltration of contaminants from the cavity 250 to the processing circuity 6. It should be noted that FIG. 2 only shows a part of the seal ring structures 10, 11 extending in the y-direction due to the partial cut away view. However, the seal ring structures 10, 11 may also extend in the x-direction outside the shown area to provide a complete protection loop.

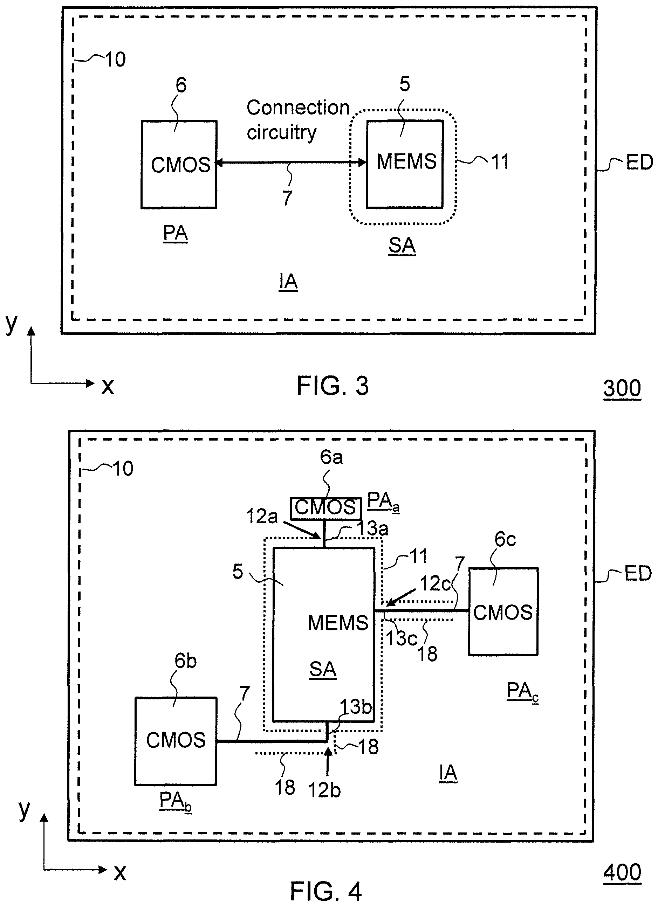

FIG. 3 shows a schematic top view of a semiconductor chip 300 according to an embodiment of the invention. The semiconductor chip 300 comprises processing circuitry 6 embodied as CMOS circuitry and a sensor device 5 embodied as MEMS circuitry. The processing circuitry 6 forms a processing area PA and the sensor device 5 forms a sensor area SA. The sensor device 5 and the processing circuitry 6 are electrically connected by connection circuitry 7, schematically indicated by a double-arrow. A first seal ring 10 is arranged at an edge ED of the semiconductor chip 300 and more particularly between the edge ED and an inner area IA of the chip 300. The first seal ring 10 is illustrated by a dashed line.

A second seal ring 11 is arranged around the sensor device 5 and more particularly between the sensor device 5 and the processing area PA of the CMOS processing circuitry 6. Preferably the second seal ring 11 is arranged rather close around the sensor area SA. This provides the advantage that the second seal ring 11 can shield also other parts of the stack, in particular the connection circuitry 7, from contaminants that may enter the stack via the sensor area SA. The second seal ring 11 is illustrated by a dotted line.

FIG. 4 shows a schematic top view of a semiconductor chip 400 according to an embodiment of the invention. The semiconductor chip 400 comprises three different processing circuitries 6a, 6b and 6c which are arranged at different positions of the chip 400. A sensor device 5 is embodied as MEMS circuitry.

The processing circuitries 6a, 6b and 6c form three processing areas PAₐ, PA_{b} and PA_{c}. The three processing areas PAₐ, PA_{b} and PA_{c} may be collectively referred to as processing area PA.

The chip 400 also comprises a first seal ring 10 which is arranged at an edge ED of the semiconductor chip 400 and more particularly between the edge ED and an inner area IA of the chip 400. The first seal ring 10 is again illustrated by a dashed line.

According to embodiments the processing area PA may include the area of the connection circuitry 7 and according to embodiments the processing area PA may be the whole area of the stack inside the first seal ring 10 with the exception of the sensor area SA.

A second seal ring 11 is arranged around the sensor device 5 and more particularly between the sensor device 5 and the processing areas PAₐ, PA_{b} and PA_{c}.

The second seal ring 11 is illustrated again by a dotted line. The second seal ring 11 comprises three openings 12a, 12b and 12c for electrical feed through connections 13a, 13b and 13c respectively. The openings 12b and 12c comprise lateral projections 18 that extend in the x-y plane from the sensor device 5 and increase the diffusion path for contaminants diffusing from the sensor area SA via the openings 12b, 12c to the processing areas PA_{b} and PA_{c} respectively.

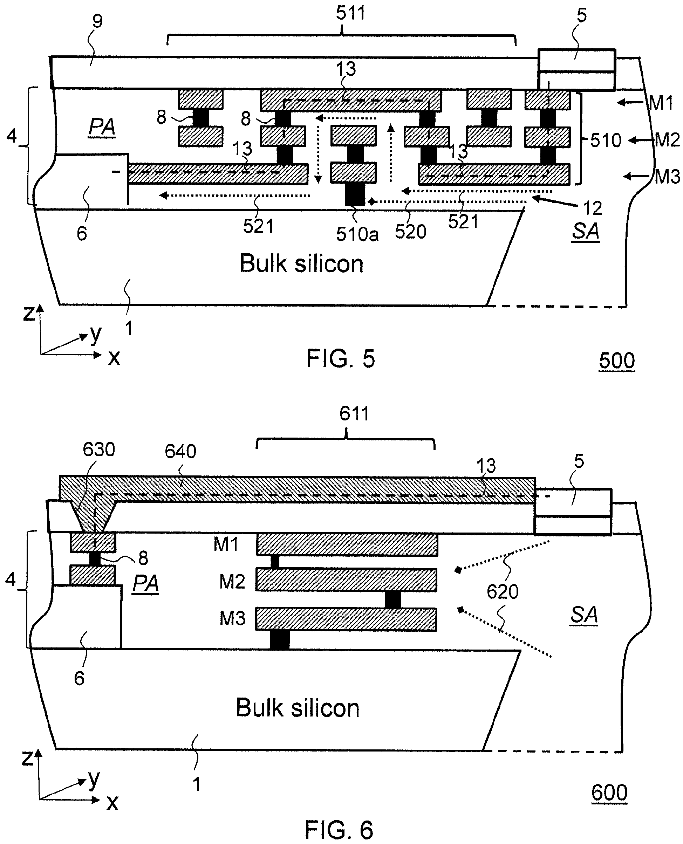

FIG. 5 shows a cross section of a semiconductor chip 500 according to an embodiment of the invention. More particularly, FIG. 5 shows a cut out cross section of a second seal ring structure 511 and a part of the adjacent processing area PA and sensor area SA. The second seal ring structure 511 is implemented by a plurality of different metal layers M1, M2 and M3. The plurality of different metal layers M1, M2 and M3 are electrically interconnected by interconnect elements 8, embodied as vias 8.

According to this embodiment the second seal ring structure 511 does not provide an electrical connection between the substrate 1 and the passivation layer 9, but rather the substrate 1 and the passivation layer 9 are electrically insulated from each other. The second seal ring structure 511 comprises as connection circuitry an electrical feed through connection 13 which is illustrated with a dashed line. The electrical feed trough connection 13 electrically connects the sensor device 5 and the processing circuitry 6 of the semiconductor chip 600. More particularly, the electrical feed through connection 13 does not provide a direct path between the sensor device 5 and the processing circuitry 6, but is arranged with a plurality of elbow connections. Thereby the electrical feed through connection 13 and the second seal ring structure 511 are formed with vertical walls 510 that block direct diffusion paths between the sensor area SA and the processing area PA. Such a direct diffusion path is illustrated with a dotted line and the reference numeral 520. The direct diffusion path 520 is blocked by a vertical wall 510a. A remaining diffusion path 521 which is also illustrated with a dotted line establishes an indirect diffusion path and is hence guided in an indirect manner around elbow connections through the second seal ring structure 11. Due to the indirect and elongated diffusion path 521 the diffusion is effectively reduced compared with the direct diffusion path 520.

FIG. 6 shows a cross section of a semiconductor chip 600 according to another embodiment of the invention. More particularly, FIG. 6 shows a cut out cross section of a second seal ring structure 611 and a part of the adjacent processing area PA and sensor area SA. The second seal ring structure 611 is implemented as conductive structure and is formed by a plurality of different metal layers M1, M2 and M3. The plurality of different metal layers M1, M2 and M3 are electrically interconnected by interconnect elements 8, embodied as vias 8.

According to this embodiment, the second seal ring structure 611 is a closed seal ring structure. The closed seal ring structure 611 provides a closed seal ring between the substrate 1 and the passivation layer 9 and hence a closed and complete diffusion barrier. The closed seal ring structure 611 is electrically insulated from the sensor device 5 and the processing circuitry 6.

According to this embodiment, an electrical connection between the sensor device 5 and the processing circuitry 6 is provided by means of a contact layer 640. The contact layer 640 may be a layer of metal and is arranged on top of a passivation layer 9, the latter being arranged on the stack 4. The contact layer 640 provides an electrical contact between the sensor device 5 and the processing circuitry 6 through an opening 630 of the passivation layer 9. The contact layer 640 contacts the stack 4 and more particularly the first metal layer M1, the latter providing an electrical connection through the stack 4 via the metal layer M2 and interconnect elements 8 to the processing circuitry 6.

As illustrated with dotted lines, any diffusion path 620 between the sensor area SA and the process area PA is blocked by the closed second seal ring structure 611.

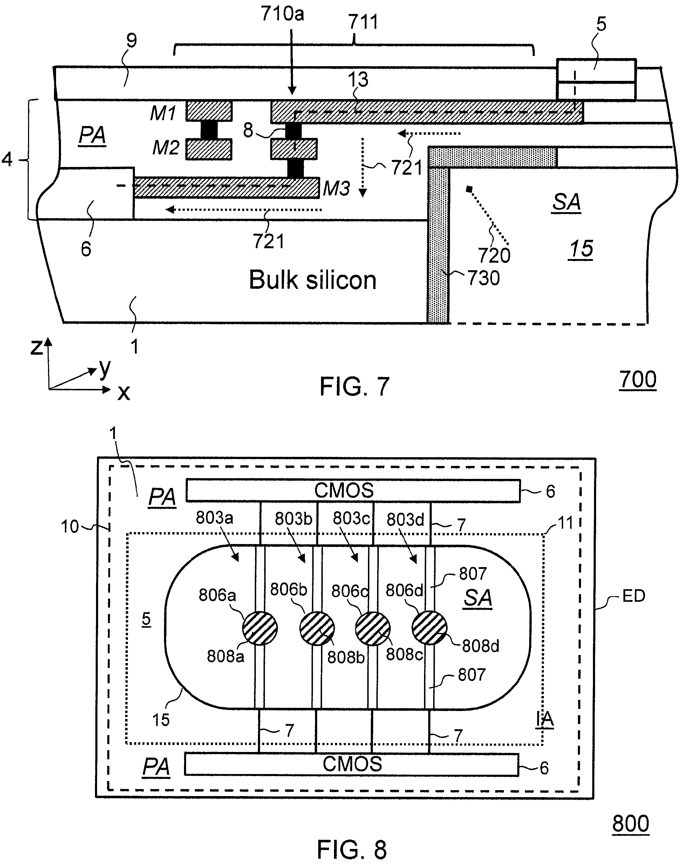

FIG. 7 shows a cross section of a semiconductor chip 700 according to another embodiment of the invention. More particularly, FIG. 7 shows a cut out cross section of a second seal ring structure 711 and a part of the adjacent processing area PA and sensor area SA. The second seal ring structure 711 is implemented by a plurality of different metal layers M1, M2 and M3. The plurality of different metal layers M1, M2 and M3 are electrically interconnected by interconnect elements 8, embodied as vias 8.

According to this embodiment, the substrate 1 and the passivation layer 9 are electrically insulated from each other. The second seal ring structure 711 comprises an electrical feed through connection 13 which is illustrated with a dashed line. The electrical feed through connection 13 electrically connects the sensor device 5 and the processing circuitry 6 of the semiconductor chip 700. The electrical feed through connection 13 is arranged with elbow connections and is formed with a vertical wall 710a that provides a bypath for a diffusion path 721 illustrated with a dotted line, thereby establishing an indirect diffusion path.

The semiconductor chip 700 comprises a further passivation layer 730 which is arranged between the sensor area SA and the processing area PA and more particularly adjacent to the sensor area SA and the second seal ring structure 711. The further passivation layer 730 extends in the vertical z-direction along the substrate 1 into the stack 4 and in the horizontal x-y plane within the stack 4. The passivation layer 730 seals the sensor area SA from the processing area PA and in particular blocks a direct diffusion path 720 between a recess 15 or opening 15 in the substrate and the stack 4.

FIG. 8 shows a schematic top view of a semiconductor chip 800 according to another embodiment of the invention. The semiconductor chip 800 is a gas sensor for detecting and/or analysing a gas and comprises a sensor device 5 and CMOS processing circuitry 6.

The semiconductor chip 800 comprises a substrate 1, in particular a substrate of silicon. The substrate 1 has an opening or recess 15 arranged therein. The sensor device 5 comprises a plurality of separate bridge structures that span this opening or recess 15. More particularly, the sensor device 5 comprises a first bridge structure 803a that forms a first hotplate 806a, a second bridge structure 803b that forms a second hotplate 806b, a third bridge structure 803c that forms a third hotplate 806c and a fourth bridge structure 803d that forms a fourth hotplate 806d. In the following it may be referred to the plurality of bridge structures collectively as bridge structures 803 and to the plurality of hotplates as hotplates 806.

The sensor device 5 comprises a first patch 808a of sensing material arranged on the first hotplate 806a, a second patch 808b of sensing material arranged on the second hotplate 806b, a third patch 808c of sensing material arranged on the third hotplate 806c and a fourth patch 808d of sensing material arranged on the fourth hotplate 806d. The sensing material may be in particular a metal oxide material.

The sensing material is a material that changes at least one electrical property (in particular the real or imaginary part of its electrical impedance) as a function of the composition of the gas that surrounds it. The change of the property can be measured in order to obtain information on said composition.

The sensing material can e.g. contain at least one metal oxide material. Such metal oxide material generally may include one or more of tin oxide, zinc oxide, titanium oxide, tungsten oxide, indium oxide and gallium oxide. Such metal oxides may be used for the detection of analytes such as VOCs, carbon monoxide, nitrogen dioxide, methane, ammonia or hydrogen sulphide.

Each of the bridge structures 803a, 803b, 803c and 803d comprises a central region and two arms 807 extending between the central regions and the substrate 1, thereby suspending the hotplates 806a, 806b, 806c and 806d over the recess or opening 2. The arms 807 extend collinear to each other and with the central region with the hotplates being arranged between them.

Each of the bridge structures 803a, 803b, 803c and 803d comprises electrodes adapted to measure electrical properties of the patches. Furthermore, each of the bridge structures 803a, 803b, 803c and 803d comprises a heater adapted to heat the hotplates and a temperature sensor to measure the temperature of the respective bridge structure. The electrodes, heaters and temperature sensors are not shown in FIG. 8 for visual clarity reasons.

The substrate 1 carries processing circuitry 6, e.g. including circuitry for driving the heaters and processing signals from the electrodes and temperature sensors. For this, the processing circuitry 6 is electrically connected to the heaters, electrodes and temperature sensors via connection circuitry 7. Advantageously, processing circuitry 6 is integrated in CMOS technology compatible with current CMOS manufacturing processes. Having the CMOS circuitry on-board of substrate 1 allows to reduce the number of bonds to the substrate and to increase signal-to-noise ratio.

Structures of the type shown in Fig. 8 can e.g. be built using techniques such as described in EP 2278308 or US 2014/0208830.

In particular, the process for manufacturing comprises the steps of forming a plurality of dielectric and metal layers on top of the substrate 1. Some of these layers may be deposited in the course of the process for forming the CMOS circuitry 6, e.g. as intermetal dielectric layer and metal layers, while other layers may be applied during post-processing, such as a tensile silicon nitride layer. Then, recess or opening 815 is formed using selective, anisotropic etching techniques. The patches 808a, 808b, 808c and 808d of sensing material can e.g. be applied using dispensing techniques where a drop or several drops of a liquid precursor of the sensing material is applied to the hotplates, such as e.g. described in EP 2952885.

The semiconductor chip 800 comprises a first seal ring structure 10 arranged between an outer edge ED of the chip 800 and the inner area IA of the chip 800 and a second seal ring structure 11 arranged between the sensor device 5 and the processing circuitry 6.

As described above and illustrated in FIG. 8, the bridge structures 803a, 803b, 803c and 803d with the integrated hotplates are freely suspended and the material of the CMOS stack has been completely removed between the hotplates/bridge structures and the CMOS. This may result in a rather direct entering path for chemicals into the CMOS stack. Hence embodiments of the invention facilitate the integration of such structures together with CMOS circuitry on a common chip and the second seal ring structure 11 effectively shields a possible entering for chemicals into the oxide stack.

Semiconductor chips according to embodiments of the invention may be used in various electronic devices, in particular in portable electronic devices. Hence aspects of the invention also improve the reliability of the sensor functions of such electronic devices.

The descriptions of the various embodiments of the present invention have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. Semiconductor chip, comprising
a substrate (1);
a stack (4) of one or more insulating layers (2) and one or more metal layers (3) arranged on the substrate (1);
a sensor device (5) arranged in a sensor area(SA) of the semiconductor chip;
processing circuitry (6) arranged in a processing area (PA) of the semiconductor chip;
connection circuitry (7) configured to provide an electrical connection between the sensor device (5) and the processing circuitry (6);
a first seal ring structure (10) arranged between an outer edge (ED) of the chip and an inner area (IA) of the chip, the inner area (IA) encompassing the sensor area (SA) and the processing area (PA); and
a second seal ring structure (11) arranged between the sensor area (SA) and the processing area (PA) and configured to constrain an infiltration of contaminants from the sensor area (SA) to the processing area (PA), wherein
the semiconductor chip comprises a passivation layer (9) arranged at least partly on top of the stack (4); the first seal ring structure (10) and the second seal ring structure (11) are implemented in the stack (4) between the substrate (1) and the passivation layer (9),
the second seal ring structure (11) is a closed seal ring structure;
the closed seal ring structure (11) provides a closed seal ring between the substrate and the passivation layer;
the closed seal ring structure (11) is electrically insulated from the sensor device (5) and the processing circuitry (6); and
the semiconductor chip comprises as connection circuitry a contact layer (640) arranged on top of the passivation layer (9), the contact layer (640) being configured to contact the sensor device (5) through an opening (630) of the passivation layer.

2. Semiconductor chip, comprising
a substrate (1);
a stack (4) of one or more insulating layers (2) and one or more metal layers (3) arranged on the substrate (1);
a sensor device (5) arranged in a sensor area(SA) of the semiconductor chip;
processing circuitry (6) arranged in a processing area (PA) of the semiconductor chip;
connection circuitry (7) configured to provide an electrical connection between the sensor device (5) and the processing circuitry (6);
a first seal ring structure (10) arranged between an outer edge (ED) of the chip and an inner area (IA) of the chip, the inner area (IA) encompassing the sensor area (SA) and the processing area (PA); and
a second seal ring structure (11) arranged between the sensor area (SA) and the processing area (PA) and configured to constrain an infiltration of contaminants from the sensor area (SA) to the processing area (PA), wherein
the second seal ring structure (11) is configured as open seal ring structure comprising one or more openings (12) for one or more electrical feed through connections (13), wherein the one or more electrical feed through connections (13) are configured to provide an electrical connection between the sensor device (5) and the processing circuitry (6);
the second seal ring structure (11) comprises a conductive structure arranged in the stack (4); and
the electrical feed through connections (13) are implemented by two or more different metal layers (M1, M2, M3) of the stack which are electrically connected by interconnect elements (8), wherein the feed through connections (13) are arranged in such a way that a direct diffusion path between the sensor area (SA) and the processing area (PA) is blocked.

3. Semiconductor chip according to claim 2,
wherein
the one or more openings (12) comprise lateral projections (18) configured to increase the diffusion length between the sensor device (5) and the processing circuitry (6).

4. Semiconductor chip according to claim 2, wherein the electrical feed through connections (13) comprise a plurality of elbow connections, in particular 90° elbow connections, and walls (510), in particular vertical walls, that block the direct diffusion path between the sensor area and the processing area.

5. Semiconductor chip according to claim 1,
wherein
the second seal ring structure (11) is a conductive structure arranged in the stack (4); and
the second seal ring structure (11) is formed by a plurality of metal layers (M1, M2, M3) which are electrically connected by interconnect elements (8).

6. Semiconductor chip according to any of the
preceding claims,
wherein the semiconductor chip comprises a further passivation layer (730) arranged between the sensor area (SA) and the processing area (PA) and configured to shield the sensor area (SA) from the processing area (PA) .

7. Semiconductor chip according to any of the
preceding claims,
wherein the sensor device (5) is a MEMS device and the processing circuitry (6) is CMOS circuitry.

8. Semiconductor chip according to any of
the preceding claims,
wherein the sensor area (SA) comprises a recess, opening or cavity (15, 250)) in the substrate.

9. Semiconductor chip according to any of
the preceding claims,
wherein the sensor area (SA) comprises a bridge structure (803a 803b, 803c, 803d), the bridge structure carrying one or more sensing elements (808a, 808b, 808c ,808d) of the sensor device (5).

10. Semiconductor chip according to any of
the preceding claims,
wherein the sensor area (SA) comprises a passivation layer (9) with at least one opening (16) in the sensor area.

11. Semiconductor chip according to any of the
preceding claims,
wherein the sensor device (5) is selected from the group consisting of:
a flow sensor;
a humidity sensor;
a gas sensor, in particular a MOX gas sensor;
an electro-chemical cell; and
an IR sensor.

12. Electronic device, in particular a portable electronic device,
wherein the electronic device comprises a semiconductor chip according to any of the preceding claims.

## Patentansprüche

1. Halbleiterchip, umfassend
ein Substrat (1);
einen Stapel (4) aus einer oder mehreren Isolierschichten (2) und einer oder mehreren Metallschichten (3), die auf dem Substrat (1) angeordnet sind;
eine Sensorvorrichtung (5), die in einem Sensorbereich (SA) des Halbleiterchips angeordnet ist;
eine Verarbeitungsschaltung (6), die in einem Verarbeitungsbereich (PA) des Halbleiterchips angeordnet ist;
eine Verbindungsschaltung (7), die so konfiguriert ist, dass sie eine elektrische Verbindung zwischen der Sensorvorrichtung (5) und der Verarbeitungsschaltung (6) herstellt;
eine erste Dichtungsringstruktur (10), die zwischen einem äußeren Rand (ED) des Chips und einem inneren Bereich (IA) des Chips angeordnet ist, wobei der innere Bereich (IA) den Sensorbereich (SA) und den Verarbeitungsbereich (PA) umfasst; und
eine zweite Dichtungsringstruktur (11), die zwischen dem Sensorbereich (SA) und dem Verarbeitungsbereich (PA) angeordnet ist und so konfiguriert ist, dass sie ein Eindringen von Verunreinigungen aus dem Sensorbereich (SA) in den Verarbeitungsbereich (PA) einschränkt, wobei
der Halbleiterchip eine Passivierungsschicht (9) umfasst, die zumindest teilweise auf dem Stapel (4) angeordnet ist;
die erste Dichtungsringstruktur (10) und die zweite Dichtungsringstruktur (11) in dem Stapel (4) zwischen dem Substrat (1) und der Passivierungsschicht (9) implementiert sind,
die zweite Dichtungsringstruktur (11) eine geschlossene Dichtungsringstruktur ist;
die geschlossene Dichtungsringstruktur (11) einen geschlossenen Dichtungsring zwischen dem Substrat und der Passivierungsschicht bereitstellt;
die geschlossene Dichtungsringstruktur (11) elektrisch von der Sensorvorrichtung (5) und der Verarbeitungsschaltung (6) isoliert ist; und
der Halbleiterchip als Verbindungsschaltung eine Kontaktschicht (640) umfasst, die auf der Passivierungsschicht (9) angeordnet ist, wobei die Kontaktschicht (640) so konfiguriert ist, dass sie die Sensorvorrichtung (5) durch eine Öffnung (630) der Passivierungsschicht kontaktiert.

2. Halbleiterchip, umfassend
ein Substrat (1);
einen Stapel (4) aus einer oder mehreren Isolierschichten (2) und einer oder mehreren Metallschichten (3), die auf dem Substrat (1) angeordnet sind;
eine Sensorvorrichtung (5), die in einem Sensorbereich (SA) des Halbleiterchips angeordnet ist;
eine Verarbeitungsschaltung (6), die in einem Verarbeitungsbereich (PA) des Halbleiterchips angeordnet ist;
eine Verbindungsschaltung (7), die so konfiguriert ist, dass sie eine elektrische Verbindung zwischen der Sensorvorrichtung (5) und der Verarbeitungsschaltung (6) herstellt;
eine erste Dichtungsringstruktur (10), die zwischen einem äußeren Rand (ED) des Chips und einem inneren Bereich (IA) des Chips angeordnet ist, wobei der innere Bereich (IA) den Sensorbereich (SA) und den Verarbeitungsbereich (PA) umfasst; und
eine zweite Dichtungsringstruktur (11), die zwischen dem Sensorbereich (SA) und dem Verarbeitungsbereich (PA) angeordnet ist und so konfiguriert ist, dass sie ein Eindringen von Verunreinigungen aus dem Sensorbereich (SA) in den Verarbeitungsbereich (PA) einschränkt, wobei
die zweite Dichtungsringstruktur (11) als offene Dichtungsringstruktur ausgebildet ist, die eine oder mehrere Öffnungen (12) für eine oder mehrere elektrische Durchführungsverbindungen (13) aufweist, wobei die eine oder die mehreren elektrischen Durchführungsverbindungen (13) so konfiguriert sind, dass sie eine elektrische Verbindung zwischen der Sensorvorrichtung (5) und der Verarbeitungsschaltung (6) herstellen;
die zweite Dichtungsringstruktur (11) eine leitende Struktur umfasst, die in dem Stapel (4) angeordnet ist; und
die elektrischen
Durchführungsverbindungen (13) durch zwei oder mehr unterschiedliche Metallschichten (M1, M2, M3) des Stapels implementiert sind, die durch Verbindungselemente (8) elektrisch verbunden sind, wobei die Durchführungsverbindungen (13) so angeordnet sind, dass ein direkter Diffusionspfad zwischen dem Sensorbereich (SA) und dem Verarbeitungsbereich (PA) blockiert ist.

3. Halbleiterchip nach Anspruch 2, wobei
die eine oder die mehreren Öffnungen (12) laterale Vorsprünge (18) umfassen, die so gestaltet sind, dass sie die Diffusionslänge zwischen der Sensorvorrichtung (5) und der Verarbeitungsschaltung (6) vergrößern.

4. Halbleiterchip nach Anspruch 2, wobei die elektrischen Durchführungsverbindungen (13) mehrere Winkelverbindungen, insbesondere 90°-Winkelverbindungen, und Wände (510), insbesondere vertikale Wände, umfassen, die den direkten Diffusionspfad zwischen dem Sensorbereich und dem Verarbeitungsbereich blockieren.

5. Halbleiterchip nach Anspruch 1,
wobei
die zweite Dichtungsringstruktur (11) eine in dem Stapel (4) angeordnete leitende Struktur ist; und
die zweite Dichtungsringstruktur (11) durch eine Mehrzahl von Metallschichten (M1, M2, M3) gebildet ist, die durch Verbindungselemente (8) elektrisch verbunden sind.

6. Halbleiterchip nach einem der vorhergehenden Ansprüche,
wobei der Halbleiterchip eine weitere Passivierungsschicht (730) aufweist, die zwischen dem Sensorbereich (SA) und dem Verarbeitungsbereich (PA) angeordnet ist und so ausgebildet ist, dass sie den Sensorbereich (SA) von dem Verarbeitungsbereich (PA) abschirmt.

7. Halbleiterchip nach einem der vorhergehenden Ansprüche,
wobei die Sensorvorrichtung (5) eine MEMS-Vorrichtung ist und die Verarbeitungsschaltung (6) eine CMOS-Schaltung ist.

8. Halbleiterchip nach einem der vorhergehenden Ansprüche,
wobei der Sensorbereich (SA) eine Ausnehmung, Öffnung oder einen Hohlraum (15, 250)) im Substrat umfasst.

9. Halbleiterchip nach einem der vorhergehenden Ansprüche,
wobei der Sensorbereich (SA) eine Brückenstruktur (803a, 803b, 803c, 803d) umfasst, wobei die Brückenstruktur ein oder mehrere Sensorelemente (808a, 808b, 808c, 808d) der Sensorvorrichtung (5) trägt.

10. Halbleiterchip nach einem der vorhergehenden Ansprüche,
wobei der Sensorbereich (SA) eine Passivierungsschicht (9) mit mindestens einer Öffnung (16) im Sensorbereich aufweist.

11. Halbleiterchip nach einem der vorhergehenden Ansprüche,
wobei die Sensorvorrichtung (5) ausgewählt ist aus der Gruppe bestehend aus:
einem Strömungssensor;
einem Feuchtigkeitssensor;
einem Gassensor, insbesondere einem MOX-GasSensor
einer elektro-chemischen Zelle; und
einem IR-Sensor.

12. Elektronisches Gerät, insbesondere ein tragbares elektronisches Gerät,
wobei das elektronische Gerät einen Halbleiterchip nach einem der vorhergehenden Ansprüche umfasst.

## Revendications

1. Puce semi-conductrice, comprenant
un substrat (1) ;
une pile (4) d'une ou plusieurs couches isolantes (2) et d'une ou plusieurs couches métalliques (3) disposées sur le substrat (1) ;
un dispositif de détection (5) disposé dans une zone de détection (SA) de la puce semi-conductrice ;
un circuit de traitement (6) disposé dans une zone de traitement (PA) de la puce semi-conductrice ;
un circuit de connexion (7) configuré pour fournir une connexion électrique entre le dispositif de détection (5) et le circuit de traitement (6) ;
une première structure d'anneau d'étanchéité (10) disposée entre un bord extérieur (ED) de la puce et une zone intérieure (IA) de la puce, la zone intérieure (IA) englobant la zone de détection (SA) et la zone de traitement (PA) ; et
une deuxième structure d'anneau d'étanchéité (11) disposée entre la zone de détection (SA) et la zone de traitement (PA) et configurée pour limiter une infiltration de contaminants de la zone de capteur (SA) à la zone de traitement (PA),
la puce semi-conductrice comprenant une couche de passivation (9) disposée au moins partiellement sur le dessus de la pile (4) ; la première structure d'anneau d'étanchéité (10) et la deuxième structure d'anneau d'étanchéité (11) étant mises en œuvre dans la pile (4) entre le substrat (1) et la couche de passivation (9),
la deuxième structure d'anneau d'étanchéité (11) étant une structure d'anneau d'étanchéité fermée ;
la structure d'anneau d'étanchéité fermé (11) fournissant un anneau d'étanchéité fermé entre le substrat et la couche de passivation ;
la structure d'anneau d'étanchéité fermé (11) étant isolée électriquement du dispositif de détection (5) et du circuit de traitement (6) ; et
la puce semi-conductrice comprenant comme circuit de connexion une couche de contact (640) disposée sur le dessus de la couche de passivation (9), la couche de contact (640) étant configurée pour entrer en contact avec le dispositif de détection (5) à travers une ouverture (630) de la couche de passivation.

2. Puce semi-conductrice, comprenant
un substrat (1) ;
une pile (4) d'une ou plusieurs couches isolantes (2) et d'une ou plusieurs couches métalliques (3) disposées sur le substrat (1) ;
un dispositif de détection (5) disposé dans une zone de détection (SA) de la puce semi-conductrice ;
un circuit de traitement (6) disposé dans une zone de traitement (PA) de la puce semi-conductrice ;
un circuit de connexion (7) configuré pour fournir une connexion électrique entre le dispositif de détection (5) et le circuit de traitement (6) ;
une première structure d'anneau d'étanchéité (10) disposée entre un bord extérieur (ED) de la puce et une zone intérieure (IA) de la puce, la zone intérieure (IA) englobant la zone de détection (SA) et la zone de traitement (PA) ; et
une deuxième structure d'anneau d'étanchéité (11) disposée entre la zone de détection (SA) et la zone de traitement (PA) et configurée pour limiter une infiltration de contaminants de la zone de détection (SA) vers la zone de traitement (PA),
la deuxième structure d'anneau d'étanchéité (11) étant configurée comme une structure d'anneau d'étanchéité ouverte comprenant une ou plusieurs ouvertures (12) pour une ou plusieurs connexions électriques traversantes (13), la ou les plusieurs connexions électriques traversantes (13) étant configurées pour fournir une connexion électrique entre le dispositif de détection (5) et le circuit de traitement (6) ;
la deuxième structure d'anneau d'étanchéité (11) comprenant une structure conductrice disposée dans la pile (4) ; et
les connexions électriques traversantes (13) étant réalisées par deux ou plusieurs couches métalliques différentes (M1, M2, M3) de la pile qui sont connectées électriquement par des éléments d'interconnexion (8), les connexions traversantes (13) étant disposées de telle sorte qu'un chemin de diffusion direct entre la zone de détection (SA) et la zone de traitement (PA) est bloqué.

3. Puce semi-conductrice selon la revendication 2, dans laquelle
l'une ou les plusieurs ouvertures (12) comprennent des saillies latérales (18) configurées pour augmenter la longueur de diffusion entre le dispositif de détection (5) et le circuit de traitement (6).

4. Puce semi-conductrice selon la revendication 2, dans laquelle les connexions électriques traversantes (13) comprennent une pluralité de connexions coudées, en particulier des connexions coudées à 90°, et des parois (510), en particulier des parois verticales, qui bloquent le chemin de diffusion direct entre la zone de détection et la zone de traitement.

5. Puce semi-conductrice selon la revendication 1, dans laquelle
la deuxième structure d'anneau d'étanchéité (11) est une structure conductrice disposée dans la pile (4) ; et
la deuxième structure d'anneau d'étanchéité (11) est formée par une pluralité de couches métalliques (M1, M2, M3) qui sont connectées électriquement par des éléments d'interconnexion (8).

6. Puce semi-conductrice selon l'une des revendications précédentes,
dans laquelle la puce semi-conductrice comprend une autre couche de passivation (730) disposée entre la zone de détection (SA) et la zone de traitement (PA) et configurée pour protéger la zone de détection (SA) de la zone de traitement (PA).

7. Puce semi-conductrice selon l'une des revendications précédentes,
dans laquelle le dispositif de détection (5) est un dispositif MEMS et le circuit de traitement (6) est un circuit CMOS.

8. Puce semi-conductrice selon l'une des revendications précédentes,
dans laquelle la zone de détection (SA) comprend une rainure, une ouverture ou une cavité (15, 250)) dans le substrat.

9. Puce semi-conductrice selon l'une des revendications précédentes,
dans laquelle la zone de détection (SA) comprend une structure de pont (803a 803b, 803c, 803d), la structure de pont portant un ou plusieurs éléments de détection (808a, 808b, 808c ,808d) du dispositif de détection (5).

10. Puce semi-conductrice selon l'une des revendications précédentes,
dans laquelle la zone de détection (SA) comprend une couche de passivation (9) avec au moins une ouverture (16) dans la zone de détection.

11. Puce semi-conductrice selon l'une des revendications précédentes,
dans laquelle le dispositif de détection (5) est choisi dans le groupe constitué par :
un capteur de débit ;
un capteur d'humidité ;
un capteur de gaz, en particulier un capteur de gaz MOX ;
une cellule électrochimique ; et
un capteur IR.

12. Dispositif électronique, en particulier un dispositif électronique mobile,
le dispositif électronique comprenant une puce semi-conductrice selon l'une des revendications précédentes.
